(19) Europäisches Patentamt
European Patent Office
Office européen des brevets

(11) **EP 4 085 733 B1**

(12) **EUROPEAN PATENT SPECIFICATION**

(45) Date of publication and mention
of the grant of the patent:
**22.04.2026 Bulletin 2026/17**

(21) Application number: **21713087.1**

(22) Date of filing: **11.03.2021**

(51) International Patent Classification (IPC):
**H05B 6/80** (2006.01)

(52) Cooperative Patent Classification (CPC):
**H05B 6/806**

(86) International application number:
**PCT/GB2021/050610**

(87) International publication number:
**WO 2021/181102 (16.09.2021 Gazette 2021/37)**

(54) **IMPROVEMENTS IN AND RELATING TO PLASMA FURNACES**

VERBESSERUNGEN AN UND IN BEZUG AUF PLASMAÖFEN

AMÉLIORATIONS CONCERNANT LES DES FOURS À PLASMA

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.03.2020 GB 202003596**

(43) Date of publication of application:
**09.11.2022 Bulletin 2022/45**

(73) Proprietor: **University Of Lancaster
Lancashire LA1 4YW (GB)**

(72) Inventors:
• **DEXTER, Amos Christopher
Lancaster Lancashire LA1 4YW (GB)**
• **MINARDS, Jarred
Lancaster Lancashire LA1 4YW (GB)**

(74) Representative: **HGF
HGF Limited
4th Floor, 1 City Square
Leeds LS1 2ES (GB)**

(56) References cited:
**EP-A2- 0 264 913       CN-U- 210 075 674
JP-A- H06 287 761       KR-B1- 101 326 670**

# EP 4 085 733 B1

## Description

### Field of the Invention

The present disclosure relates to a method and apparatus for supplying electromagnetic power to a plasma vessel such that electromagnetic energy can be used for generating a plasma. In particular, the disclosure is concerned with efficiently supplying power to a vessel incorporated into a plasma furnace (or plasma torch) which may generate plasmas for use in industrial processing such as for waste destruction and chemical synthesis.

### Background

The use of plasma furnaces in industrial processes such as gas phase chemical processing is well known. One example is the removal of harmful components from toxic and biologically contaminated material whilst leaving behind beneficial components (e.g. combustible material). Another example is in the production of a synthetic gas.

Commercial plasma furnaces relevant to industrial processing are usually operated with silica containment vessels (or tubes) inside a microwave cavity in which the plasma is generated, as will be familiar to those skilled in the art. Silica is an insulator, and as such these silica vessels reduce electron losses from the gas/plasma within the cavity, thereby aiding in maintaining the plasma temperature and a stable plasma state.

A problem with such vessels however is that they require significant cooling in order to remain functional, otherwise the containment tube fails and the plasma extinguishes. Thus this process has low efficiency in terms of energy usage, and is therefore expensive to run.

Alternatively, plasma vessels without any silica containment can be used; however in this instance much greater power is required to obtain the same heating effect to combat heat and electron loss. Plasmas generated in these vessels tend to be unstable, and the process is again inefficient in terms of energy usage and so, again, expensive to run.

Industrial plasma processing of waste and bulk materials requires high efficiency to be commercially viable. Therefore, it is highly desirable to provide a technique for plasma processing with increased energy efficiency.

The example embodiments have been provided with a view to addressing at least some of the difficulties that are encountered with current plasma furnaces, whether those difficulties have been specifically mentioned above or will otherwise be appreciated from the discussion herein.

In the related art, JP H06 287761 discusses a plasma processing apparatus for manufacturing a semiconductor element or the like using a low-temperature plasma, EP 0 264 913 A2 discusses a plasma processing apparatus, KR 101 326 670 B1 discusses a circulating fluidized plasma gasifier equipped with microwave plasma torch, and CN 210 075 674 discusses a non-jet atmospheric pressure thermal plasma generator.

### Summary

It is an object of the present invention to overcome at least one of the above or other disadvantages.

The present invention is defined according to the independent claims. Additional features will be appreciated from the dependent claims and the description herein. Any embodiments which are described but which do not fall within the scope of the claims are to be interpreted merely as examples useful for a better understanding of the invention.

Described herein is a method for supplying electromagnetic power to a plasma vessel for the generation of a plasma. The method comprises receiving, from an electromagnetic source, electromagnetic power in a rectangular waveguide mode, converting the electromagnetic power in the rectangular waveguide mode to electromagnetic power in a cylindrical waveguide mode, and transmitting the electromagnetic power in cylindrical waveguide mode to a plasma generation region of the plasma vessel.

The cylindrical waveguide mode either matches or is topologically similar to a TE0n cylindrical mode (n being a positive integer), and preferably is the TE01 cylindrical waveguide mode.

Providing power in a cylindrical waveguide mode prevents the plasma being generated too close to an edge of the plasma vessel, thereby reducing thermal and electron losses and so requiring less energy to sustain the plasma.

The rectangular waveguide mode may be the TE10 mode, which is the typical operating mode for existing microwave power generators.

Converting from the TE10 rectangular waveguide mode to a TE0n cylindrical waveguide mode may comprise converting the rectangular TE10 mode in a standard width waveguide to a rectangular TE20 mode in a double width waveguide, and converting the TE20 mode to the TE0n cylindrical mode in a cylindrical waveguide.

Also described herein is a mode converter configured to perform the aforementioned method so as to receive microwave or radio frequency power in a rectangular waveguide mode and transmit electromagnetic power in a cylindrical waveguide mode to a plasma vessel. The mode converter comprises a single width rectangular waveguide, a double width rectangular waveguide connected to the single width rectangular waveguide, and a cylindrical waveguide connected to the double width rectangular waveguide. The single width waveguide receives the initial power electromagnetic power in a rectangular waveguide mode, while the double width rectangular waveguide and cylindrical waveguide act in combination to convert and transmit the received electromagnetic power to electromagnetic power in a cylindrical waveguide mode.

The single width rectangular waveguide may be a standard width rectangular waveguide for receiving and propagating electromagnetic power in the TE10 mode.

The double width rectangular waveguide may be positioned at 90 degrees to the single width waveguide. The single width waveguide may comprise a blind alley to reflect electromagnetic power toward the double width waveguide. In this way conversion from a single width rectangular mode to a double width rectangular mode, e.g. from TE10 to TE20, may be efficiently achieved.

The corners of the blind alley may be rounded to improve the efficiency of the reflection toward the double width waveguide.

The corners at the junction between the single width rectangular waveguide and double width rectangular waveguide may also be rounded so as to improve efficiency of conversion to the double width mode.

The cylindrical waveguide may have a diameter greater than 1.22 times the free space wavelength of the electromagnetic power, and the diameter may be larger than the double width rectangular waveguide. These dimensions allow for efficient conversion to the cylindrical waveguide mode.

The cylindrical waveguide may comprise insertions along the waveguide so as to distort the circular symmetry of the waveguide and thereby suppress manifestation of unwanted waveguide modes. A pair of insertions may be disposed on opposite sides of the cylindrical waveguide and with central axes aligned parallel to the short walls of the single and double width rectangular waveguides.

Also described herein is a plasma vessel comprising a substantially circular cross section configured to receive and propagate electromagnetic power in a cylindrical waveguide mode. The plasma vessel may be formed from a conducting material so as to efficiently receive and propagate electromagnetic power in a cylindrical waveguide mode.

The plasma vessel may comprise a conical section which defines a plasma generation region of the plasma vessel. The conical section focusses (compresses) the electric field of the cylindrical waveguide mode power so as to manipulate the location of the plasma.

The plasma vessel may comprise one or more cylindrical sections. A cylindrical separating section separates the conical section from an electromagnetic power input to the plasma vessel, so that the conical section may be readily distanced from the power input (i.e. from a mode converter). A cylindrical cut off section provides an outflow nozzle for the plasma vessel as well as a cut off mode for the cylindrical waveguide mode electromagnetic power.

The plasma vessel may further comprise an ignition tube penetrating the conical section and a probe inserted through the ignition tube which may initiate heating of the plasma, as well as an inlet by which solid particles may be introduced into the conical section.

In an aspect of the invention there is provided a plasma furnace comprising an aforementioned plasma vessel and an aforementioned mode converter.

The plasma vessel is electrically insulated from the mode converter by a continuous space separating the two components. In this way it is not necessary to use other forms of insulation such as a silica tube. The gap may also provide an inlet for gas flow into the plasma vessel. Injection of the gas into the gap may be in part tangential so as to create a swirl of gas within the plasma vessel.

The gap may be surrounded a choke structure which absorbs or reflects low levels of electromagnetic field existing in modes other than the desired cylindrical modes.

Power to the furnace may be supplied by a magnetron which delivers power with frequency in the range of 100 MHz to 20 GHz, and also in the rectangular TE01 waveguide mode.

In another aspect of the invention there is provided a method of plasma processing a gas using the aforementioned furnace. The plasma processing may operate at gas pressures in the range 0.1 to 10 bar, preferably 1 bar, and using any of steam, carbon dioxide, or air as the input gas.

**Brief Description of the Drawings**

For a better understanding of the present disclosure reference will now be made to the accompanying drawings, in which:

Fig. 1 shows an example prior art plasma vessel; and
Fig. 2 shows an improved method of supplying electromagnetic power to a plasma vessel;
Fig. 3 shows the example improved method applied to a plasma vessel; and
Fig. 4 shows an apparatus to supply electromagnetic power to a plasma vessel.

**Detailed Description**

At least some of the following example embodiments provide an improved method and apparatus of supplying electromagnetic power to a plasma vessel. As will be familiar to those skilled in the art, the term electromagnetic power here refers to energy transferred from electromagnetic radiation to a medium - e.g. a plasma. At least some example embodiments improve an efficiency of the plasma generation. Many other advantages and improvements will be discussed in more detail herein.

The plasmas which are the subject of the present disclosure are formed from molecular gases (preferably polyatomic gases) and are partially ionised. To heat the molecular gas to form a plasma, free electrons in the gas are accelerated by electromagnetic fields to achieve average election energies of the order of 1 eV and above. This energy is sufficient to excite molecular modes of vibration in the gas. Scattering of the electrons from other charges within the gas randomises the electronic motions beyond merely obeying the electromagnetic field. When the cross section for vibrational excitation is very large then the predominant mechanism for ionisation of molecules can be by the collision of hot neutral molecules with other molecules, atoms and ions. This process is referred to as thermal ionisation and, suitably, is beneficial for maintaining the plasma state of the gas. If the cross section for vibrational excitation is moderate then many electrons can gain sufficient energy for ionising collisions and the predominant ionisation mechanism is electronic.

Typically, the relevant electromagnetic field is an electric field with frequency in the Microwave (MW) or Radio Frequency (RF) bands. Usually, RF and MW generated plasmas are established at sub atmospheric pressures (on the order of $10^{-3}$ bar). However, the rate at which gas phase chemical processing takes place is limited by the density of the gas/plasma, and as such higher density allows for faster processing rate. Suitably, to better establish an economically viable plasma process for low value or waste products, it is desirable to run the process near atmospheric pressure or above to achieve a suitable gas/plasma density. Here near atmospheric pressure is taken to mean any pressure in the range of substantially 0.1 bar to 10 bar. Preferably the plasma processing of the present invention is run at 1 bar, which allows for cost-effective high-volume processing.

One approach to operating stable MW plasmas around atmospheric pressure is to limit the diffusion and field driven drift of electrons onto the walls of the containment vessel. Here, a stable MW or RF generated plasma is understood to be one with a diffuse and steady high temperature zone with either sufficient temperature for the thermal ionisation of molecules or a low enough density for electronic ionisation. That is, under the repeated action of the electric field, the mean free path of electrons in the plasma is sufficient for a few to reach energies which are sufficient to cause ionisation. A non-diffuse, unsteady plasma might have many rapidly moving streamers or arcs.

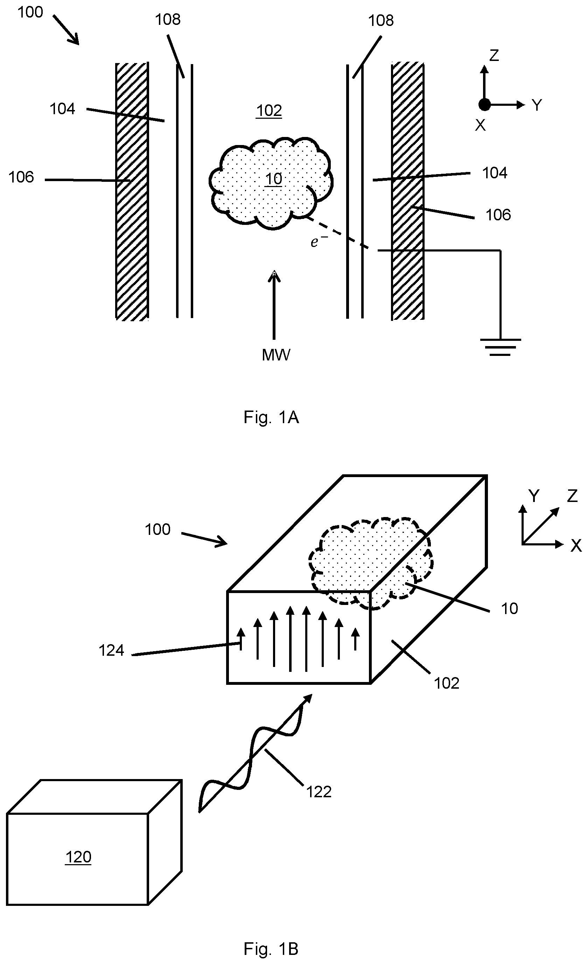

Figure 1A shows an example prior art plasma vessel 100 designed to limit electron drift towards walls 106 of the vessel 100. The vessel 100 comprises a waveguide cavity 102 comprising a fused silica surface 104 which is typically implemented as a silica tube inserted into the waveguide cavity 102. MW energy propagates through the cavity 102 in the Z direction.

A plasma 10 is generated within the cavity 102 and sustained by the MW field. Some electrons from the plasma 10 will impact the silica surface 104. These electrons form a charged layer 108 on the silica surface 104 and cause a repulsive effect on further electrons travelling toward the walls 106. In this way, once a suitable charge has built upon the silica surface 104, further electrons are prevented from reaching the silica surface 104.

More specifically, the electron layer 108 limits the electronic diffusion of the plasma 10 such that ambipolar diffusion becomes the dominant boundary constraint on the plasma 10. Ambipolar diffusion is a slower process than electronic diffusion, and therefore charge particle losses from the plasma are greatly reduced compared to a vessel without a silica surface.

One problem, however, is the fused silica 104 usually needs to be force cooled because fused silica starts to devitrify above 1100 $^0$C, becoming brittle with an increased risk of failure. Thus the overall efficiency of plasma processing in the plasma vessel is reduced.

Figure 1B shows a perspective view of the same prior art vessel 100 being driven by a prior art MW power source 120. Here the MW power source 120 transmits MW power to the plasma 10 in a rectangular TE10 waveguide mode. That is, MW power source 120 generates a MWfield 122 which propagates through the waveguide 102 with linear electric field polarisation 124 parallel to the short side of the rectangular waveguide 102 in the well-known TE10 waveguide mode. The MW field 122 has a half sinusoidal shape in the X-Y plane of the waveguide 102, being weaker near the (short) edges and stronger toward the centre. The MW field 122 accelerates the electrons in the plasma 10 to heat it via the process described above. Although the field polarisation 124 is shown pointing in the upwards Y direction, it will be appreciated that the polarisation 124 oscillates with the MW field frequency - i.e. reversing between up and down - such that there is zero net acceleration of electrons towards the long edges of the waveguide 102.

One problem with this arrangement, however, is that the fused silica tube is proximate to the high electric field 124 of the TE10 mode where significant heat is being produced to generate the plasma, particularly towards the centre of the long edges of the waveguide 102. Thus heat is transferred to the silica surface 104 of the cavity 102 causing the devitrification of the silica and instability of the plasma 10, thereby reducing efficiency of the plasma processing.

**A method for improving power efficiency in a plasma vessel**

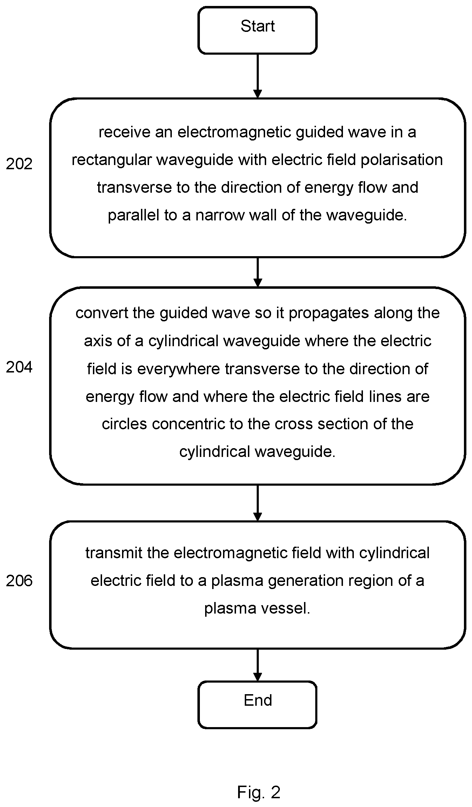

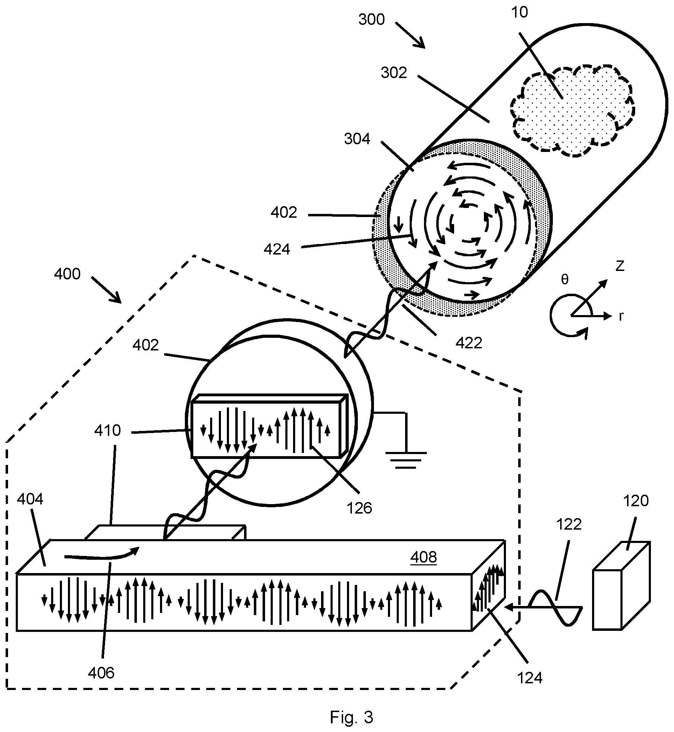

Figure 2 shows an improved method of supplying electromagnetic power to a plasma vessel and maintaining a stable plasma with high efficiency. In particular, the improved method allows for use of a plasma vessel that does not require a silica surface, and so does not have the energy losses associated with such a feature (e.g. force cooling). Figure 3 shows an example of the improved method as applied to a plasma vessel 300. The components of Figure 3 are shown separated for convenience of illustration however it will be appreciated that in a typical implementation of the method the components will be contiguous.

In step 202, electromagnetic power 122 (i.e. an electromagnetic guided wave) is transmitted from an electromagnetic source 120 in a rectangular waveguide mode 124. Typically, the mode 124 is the TE10 mode where the electric field is parallel to the short side of a rectangular waveguide and is perpendicular to the direction of propagation, as would normally be produced by a high-power microwave generator. The rectangular waveguide mode 124 is received by a mode converter 400 positioned downstream of the electromagnetic source 120 and upstream of the plasma vessel 300.

Preferably the electromagnetic source 120 is a MW generator; as mentioned previously however other sources, such as an RF generator, could also be used. Thus, the electromagnetic power provided for generating the plasma is preferably MW power. In the following a MW power generator 120 will be assumed.

Preferably the mode converter 400 is separate to the plasma vessel 300, but may also be considered as a component part thereof. Alternatively the mode converter 400 could be configured as a specialised launcher for the electromagnetic source 120.

In step 204 the received rectangular mode electromagnetic power 122 is converted to electromagnetic power 422 in a cylindrical waveguide mode 424. That is, the mode converter 400 converts the rectangular mode power 122 to electromagnetic power 422 in a TE01 cylindrical or TE0n cylindrical mode (n being a positive integer) propagating in cylindrical waveguide 402. For a cylindrical TE0n mode the electric field 424 is perpendicular to the direction of propagation and circulates concentrically in the plane of the waveguide circular cross section. The electric field 424 is purely transverse to the axis of the circular cross section and has no zeros of the electric field 424 around the axis, and also has direction which everywhere follows the contour of the outer wall of the cylindrical waveguide 402.

More specifically, the electric field $\underline{E}(r, z, t)$ and the magnetic flux densities $\underline{B}(r, z, t)$ of the TE0n modes in a cylindrical waveguide of radius a and with its axis in the z direction is determined by the equations:

$$B_z(r, z, t) = A_n J_o \left( U'_n \frac{r}{a} \right) ex\,p\{j(k_z z - \omega t)\}, \qquad (1)$$

$$E_z = 0 \quad E_r = 0 \quad B_\theta = 0, \qquad (2)$$

$$E_\theta(r, z, t) = -\frac{\omega}{k_z} B_r = -A_n \frac{j\omega a}{U'_n} J'_o \left( U'_n \frac{r}{a} \right) exp\{j(k_z z - \omega t)\}. \qquad (3)$$

The complex number representation is used for sinusoidal electromagnetic electric and magnetic flux densities. The symbol j takes its usual engineering meaning as the square root of negative one. The angular frequency is given by $\omega$. Symbols r and $z$ are radius and axial displacement of the field point respectively. The velocity of light is given by c. $A_n$ is the amplitude of the field. $U'_n$ is the nth zero of the first differential of the first order Bessel function $J'_o(x) = 0$. The symbol $k_z$ is the wavenumber determined by the expression:

$$k_z = \sqrt{\frac{\omega^2}{c^2} - \frac{U'^2_n}{a^2}}. \qquad (4)$$

To convert the rectangular mode power 124, the mode converter 400 first converts rectangular TE10 power 124 to rectangular TE20 power 126. This is achieved by having the TE10 mode wave 124 reflect from a blind alley 404 in order to turn a 90 degree bend 406 between a TE10 supporting rectangular waveguide 408 and a TE20 supporting waveguide 410. The TE20 supporting waveguide 410 is double the width of the TE10 waveguide 408. The TE20 power 126 then propagates along the double width rectangular waveguide 410 towards the circular waveguide 402. The circular waveguide 402 does not support propagation of the TE20 mode and so the electric field is converted to a cylindrical waveguide TE0n mode.

The cylindrical TE01 mode would be used for small diameter systems with diameter less than several free space wavelengths (that is, the wavelength of the MW power in free space). The diameter of the cylindrical waveguide must be greater than 1.22 times the free space wavelength for the cylindrical TE01 mode to exist. Larger diameter systems would use TE0n modes where n is increased with diameter.

In step 206 the electromagnetic power 422 in cylindrical waveguide mode 424 is transmitted to a cavity 302 of the plasma vessel 300. The cavity 302 may be considered to be a waveguide cavity within the plasma vessel 300. In this way electromagnetic energy is provided to a gas present in the cavity 302 so as to energise the gas into a plasma 10.

It will be apparent that the electric field lines 424 of the TE0n cylindrical modes circulate about an axis of the plasma vessel 300 along which gases flow - i.e. the Z axis in Figure 3. There is no electric field 424 in the direction of the Z axis, nor is there any component of the electric field 424 connecting with, or directed toward, an inner surface 304 of the plasma vessel 300.

In the case of the TE01 mode, the electric field 424 is weakest at the waveguide axis and near the surface 304, as indicated by the relative length of the arrows 424 in Figure 3. Thus heating of the plasma is achieved in a ring far from the surface 304 of the plasma vessel 300, meaning there is less heat loss from the plasma 10 to the surface 304. This results in much more stable plasma generation and therefore greater energy efficiency compared to other prior art systems.

It will also be appreciated that topological similarity to a TE0n modes include cases where the cross section of the field 424, and of the plasma vessel 300 supporting such a field, may be distorted from a perfect circle; for example being oval, elliptical or generally having some flattened faces. Suitably any substantially cylindrical shape is viable provided the electric equipotentials keep the same relative directions with respect to the modified contouring. That is, the electric field follows the shape of the plasma vessel 300 (more specifically the waveguide cavity 302) such that there are no components of the electric field 424 acting toward a surface of the cavity 302 of the plasma vessel 300.

### Implementing the method

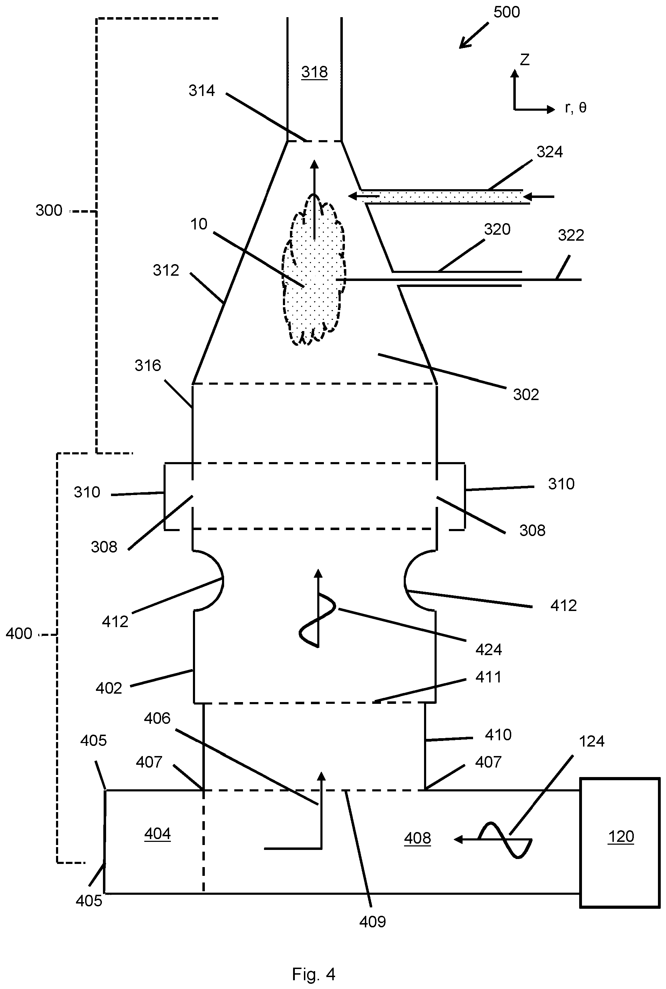

Figure 4 shows a plasma furnace 500 arranged to make use of the above method of plasma generation. The plasma furnace 500 comprises a generator 120, such as a MW source, a plasma vessel 300 and a rectangular to cylindrical mode converter 400. The generator 120, plasma vessel 300 and mode converter 400 are arranged in the same fashion as in Figure 3.

Preferably the generator 120 is a magnetron which delivers power 122 in only the rectangular TE01 mode of a standard size waveguide, such as described by R. G. Carter, "Microwave and RF Vacuum Electronic Power Source" Cambridge University Press 2018. Further preferably the electromagnetic source 120 provides electromagnetic waves with frequencies in the range of 100 MHz to 20 GHz. Magnetrons are generally used because they are cheaper and more efficient than other known types of MW generator.

As described above, the mode converter 400 receives the linearly polarised electromagnetic power 122 in the TE10 mode 124 from the generator 120, and converts the rectangular TE10 mode to the cylindrical TE01 mode.

For efficient conversion of the rectangular TE20 mode 126 to circular TE0n mode 424 it is desirable that the diameter of the circular waveguide 402 is slightly larger than the double width waveguide 410. The efficiency is also affected by the dimensions of the double width waveguide 410 and the dimensions of the blind alley.

Insertions 412 may also be made in the circular waveguide to eliminate conversion to unwanted modes like the cylindrical TE11 mode. The radius of the insertions 412 and distance from the TE20 to TE0n junction also effect the efficiency of the suppression of unwanted modes. The insertions 412 preferably take the form of cylinders pushed into the waveguide 402. In the example shown a pair of insertions 412 are provided symmetrically on opposite sides of the waveguide 402 such that the central axis of the cylinders is parallel with the short walls of the rectangular waveguides 408, 410.

Ideally all the energy arriving in the rectangular mode is converted to the cylindrical mode 424 with zero reflection and zero conversion to unintended modes. Using the parameters shown in Table 1 an example mode converter 400 has been found to achieve a conversion efficiency from TE10 to TE01 of over 99%.

| Parameter | Value (mm) |
|---|---|
| Width of rectangular waveguide carrying TE10 mode 408 | 86 |
| Height of rectangular waveguide carrying TE10 mode 408 | 43 |
| Length of rectangular waveguide to closed end 405 (blind alley 404) on waveguide carrying TE10 mode. | 80 |
| Radius of curvature on short wall corners at end of rectangular waveguide to closed end 405 (blind alley) | 20 |
| Length of wide rectangular waveguide carrying TE20 mode 410 (between dashed lines fig 4) | 92 |
| Radius of curvature on short wall corner of join 407 between rectangular waveguide carrying TE10 mode 408 and wide rectangular waveguide carrying TE20 mode 410 | 15 |
| Radius of curvature on long wall corner of join 409 between rectangular waveguide carrying TE10 mode 408 and wide rectangular waveguide carrying TE20 mode 410 | 0 |
| Radius of curvature on short wall corner of join between wide rectangular waveguide carrying TE20 mode 410 and cylindrical waveguide 402 | 0 |
| Radius of curvature on long wall corner of join 411 between rectangular waveguide carrying TE20 mode 410 and cylindrical waveguide 402 | 15 |
| Length of cylindrical waveguide 402 to gap 308 | 200 |
| Diameter of cylindrical waveguide 402 | 181 |
| Radius of semi-cylindrical insertions in cylindrical waveguide 402 | 30 |
| Distance from rectangular waveguide carrying TE20 mode 410 to axis of semi-cylindrical insertion 412 in cylindrical waveguide 402 | 92 |

*Table 1*

To achieve the correct cylindrical mode output 424, the mode converter 400 is designed by parameterising the above dimensions in a suitable topology then identifying by simulation how they can be systematically adjusted to move the design towards suitable efficiency. Thus the precise dimensions of the waveguide launcher can be readily adapted for different applications.

The plasma vessel 300 receives the electromagnetic power in a TE0n mode 424 transmitted by the rectangular to cylindrical mode converter 400. As the electromagnetic power 424 propagates in a gas provided in the cavity 302, the gas transitions to a plasma state 10.

The plasma vessel 300 is formed from a conducting material, preferably metal, so as to support propagation of the cylindrically polarised electromagnetic power 422 through the plasma vessel 300, and in particular the cavity 302. The cavity 302 is further preferably provided with a substantially circular cross section (in an $r,\theta$ plane perpendicular to the axis of propagation Z) so as to substantially match the shape of the cylindrical field 424. The circular cross section prevents unwanted non-cylindrical field modes (particularly rectangular modes) from manifesting.

The plasma vessel 300 is electrically insulated from the mode converter 400. This is achieved by incorporating a continuous gap, or cut, 308 between the plasma vessel 300 and the mode converter 400 in order to electrically separate the components. The gap 308 may be substantially circular in shape, being defined by the dimensions of the waveguide 402

7

and plasma vessel 300. In this way the electric field 424 is locally parallel to the gap 308, so that the electric field 424 has direction which everywhere follows the contour of the gap 308. Provided the gap 308 is small enough it does not interfere with propagation of the cylindrical waveguide mode 424; that is, there is minimal reflection of electromagnetic power 422 as it passes the gap 308. Moreover, the gap 308 prevents other electromagnetic power modes (e.g. non TE0n modes) from propagating across it. Preferably the gap 308 is 3 mm wide, however in general the gap could be as small as 1 mm and still achieve the insulating effect.

Suitably the gap 308 may be surrounded a choke structure 310. The choke structure 310 may be provided to absorb or reflect low levels of electromagnetic field existing in modes other than TE0n modes when the field crosses the cylindrical gap 308. Suitably the choke structure will have a continuous gap that could be filled with an insulating material.

The gap 308 allows for improved efficiency of the plasma generation process. Breaking the electrical connection between the mode converter 400 and the plasma vessel 300 ensures there is no connection back to the anode of the generator 120 (i.e. to ground), as there is for typical prior art systems. Also the inner walls 304 of the vessel 300 can become electrically charged by electron deposition from the plasma 10 in order to further reduce electron losses from the plasma 10, analogous to the process described above in relation to a silica surface. As there are fewer electron losses by conduction to the generator 120 anode (or the mode converter 400, which may be grounded), it is easier to maintain stability of the plasma 10 compared with prior art systems. Accordingly, less energy input is required to maintain the plasma 10 thereby improving the efficiency of the plasma generation; i.e. less electromagnetic power is required to maintain a stable plasma state.

Furthermore, as the gap 308 allows for a significant reduction in electron losses, there is no requirement to use a silica surface 104 to achieve the same effect. As such there is no additional apparatus and energy cost associated with cooling the (non-existent) silica surface, thereby also improving the efficiency of the plasma generation. More generally, there is no need for any form of insulating lining on the inner wall 304 of the plasma vessel 300 (e.g. an insulating coating or having an inner wall made from an insulating material).

Of course it will be appreciated that devices with silica surfaces 104 may still be utilised with this method, for example if the present plasma generation method is utilised in conjunction with prior art plasma vessels 100, however the efficiency gains from providing the cut 308 will not be realised.

The gap 308 (in combination with the choke structure 310) may also provide a secondary function of a gas input to the cavity 302. That is, gas may flow into the plasma vessel 300 through the gap 308. The gas flow may be injected into the gap 308 tangentially to the circular cross section so as to create a swirl of gas inside the plasma vessel. Put another way, the gas may be injected through the gap 308 with a component of velocity that is in the plane of the circular cross section of the gap 308 and plasma vessel 300, but deliberately directed away from the central axis of the cross section such that the gas rotates.

Many types of gases may be used as the basis for the plasma processing. For example, plasmas for chemical synthesis often use Argon as the diluent. In the case of producing a synthetic gas (syngas), it is desirable to use a low cost, non-oxidising gas that does not dilute the final product. As such the primary gas choices for syngas production are steam and carbon dioxide. Where the purpose of the plasma processing is the destruction of toxic vapours the feed gas would preferably be air.

The plasma vessel 300 may be suitably formed from one or more conical and cylindrical sections. A conical section 312 may be used to intensify the electric field 424 so as to improve plasma generation, and as such a conical section 312 may also be regarded as defining a plasma generation region of the plasma vessel 300. The conical section 312 may serve an additional purpose of directing gas/plasma 10 flow towards an outlet 314 of the plasma vessel.

A cylindrical separating section 316, may be provided proximate to the mode converter 400 so as to be the part of the plasma vessel 300 which first receives the cylindrically polarised electromagnetic power 424 from the cylindrical waveguide 402. In a configuration incorporating the gap 308, the cylindrical separating section 316 is a section of the plasma vessel 300 adjacent to the gap 308 across from the waveguide 402. The cylindrically polarised electromagnetic power 424 may propagate along a length of the cylindrical section 316 without significant loss. In this way the conical section 312 and outflow 314 may be separated from the mode converter 400 in such a way that the plasma furnace 500 may be adapted to any suitable size for a desired use.

A cylindrical cut off section 318 may be provided at the outflow 314 of the plasma vessel 300. That is, the cylindrical sections 316, 318 may be provided on opposite sides of the conical section 312. The cylindrical cut off section 318 is dimensioned to provide a cut off mode for the cylindrically polarised electric field 424 such that electromagnetic power 424 cannot propagate beyond the cylindrical cut off section 318. Thus microwave leakage which may be possible before the plasma is struck, and after the plasma becomes extinguished, may be reduced, thereby improving safety during use of the device. Leakage during running of a plasma process is not normally an issue because the plasma 10 absorbs all the microwave energy. The cylindrical cut off section 318 also provides a nozzle so as to better control the outflow from the plasma vessel 300, and may be dimensioned to minimise a pressure drop during extraction of gasses.

The plasma vessel 300 may further comprise an ignition tube 320 and a probe 322. The ignition tube 320 is hollow such that the probe 322 may be inserted along the tube. The probe 322 may be formed from a length of metal rod or wire comprising a sharp point attached to a nonconducting rod.

The ignition tube 320 penetrates the plasma vessel 300 at a point adjacent to the plasma generation region, such that when the probe 322 is inserted through the tube 320 the sharp point of the probe 322 is substantially aligned with the cylindrical electric field 424 in the $r,\theta$ plane. In this way the probe 322 intensifies the electric field at the sharp point so as to improve heating of the plasma by the electric field. In addition the point of the probe 322 may become hot enough to contribute electrons to the plasma by thermionic emissions.

In the present example the ignition tube meets the plasma vessel 300 in the conical section 312, and is dimensioned so as to prevent the propagation of the electromagnetic power 424 along the tube 320; i.e. the size of the ignition tube 320 acts as a cut-off for the frequency of electromagnetic power 424 used to generate the plasma 10.

The plasma vessel 300 may also comprise an inlet 324 by which solid particles are introduced into the plasma generation region of the plasma vessel - i.e. the conical section 312 - so as to be processed with the gas.

In summary, exemplary embodiments of an improved technique for generating plasma in a plasma vessel have been described. An example method includes receiving an electromagnetic guided wave in a rectangular waveguide with electric field polarisation transverse to the direction of energy flow and parallel to a narrow wall of a waveguide, converting the guided wave so it propagates along the axis of a cylindrical waveguide where the electric field is everywhere transverse to the direction of energy flow and where the electric field lines are circles concentric to the cross section of the cylindrical waveguide, and transmitting the electromagnetic field with cylindrical electric field to a plasma generation region of a plasma vessel.

The exemplary techniques can be applied with components manufactured industrially. An industrial application of the example embodiments will be clear from the discussion herein.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

**Claims**

1. A plasma furnace (500) comprising:

   an electrically conductive plasma vessel (300) comprising a substantially circular cross section configured to receive and propagate electromagnetic power in a transverse electric cylindrical waveguide mode which everywhere follows the contour of the shape of the plasma vessel, and
   a mode converter (400) configured to convert electromagnetic power received in a rectangular waveguide mode to electromagnetic power in a transverse electric cylindrical waveguide mode, and supply that converted power to the plasma vessel (300), and
   **characterized in that**
   the plasma vessel (300) is electrically insulated from the mode converter (400) by a continuous gap, and the cylindrical waveguide mode has electric field locally parallel to the gap.

2. The plasma furnace (500) of claim 1, wherein the continuous gap (308) is surrounded a choke structure (310).

3. The plasma furnace (500) of any of claims 1 or 2, wherein the continuous gap (308) provides an inlet for gas flow into the plasma vessel (300).

4. The plasma furnace (500) of any preceding claim, wherein the plasma vessel (300) comprises a conical section which defines a plasma generation region of the plasma vessel (300).

5. The plasma furnace (500) of claim 4, wherein the conical section of the plasma vessel (300) compresses an electric field of the electromagnetic power in the cylindrical waveguide mode.

6. The plasma vessel (300) of claims 4 or 5, wherein a cylindrical separating section spaces the conical section of the plasma vessel (300) from the continuous gap (308).

7. The plasma furnace (500) of any preceding claim, wherein the plasma vessel (300) comprises a cylindrical cut off section (318) dimensioned to provide a cut off mode for the cylindrical waveguide mode electromagnetic power while minimising a pressure drop during extraction of gasses.

8. The plasma furnace (500) of any preceding claim, wherein the plasma vessel (300) comprises an ignition tube (320) penetrating the conical section and a probe (322) inserted through the ignition tube (320).

9. The plasma furnace (500) of any preceding claim, wherein the mode converter (400) comprises a single width rectangular waveguide (408), a double width rectangular waveguide (410) connected to the single width rectangular waveguide (408), and a cylindrical waveguide (402) connected to the double width rectangular waveguide (410).

10. The plasma furnace (500) of claim 9, wherein the diameter of the cylindrical waveguide (402) is greater than 1.22 times the free space wavelength and is larger than the double width rectangular waveguide (410).

11. The plasma furnace (500) of claim 9 or 10, wherein the mode converter (400) comprises a pair of cylindrical insertions (412) symmetrically opposed on the cylindrical waveguide and with central axes aligned parallel to a short wall of the single and double width rectangular waveguides.

12. The plasma furnace (500) of any preceding claim configured to receive and propagate electromagnetic power with frequency in the range 100 MHz to 20 GHz.

13. The plasma furnace (500) of any of preceding claim, further comprising a magnetron which delivers power in the rectangular TE01 mode.

14. A method of plasma processing a syngas using a plasma furnace (500) according to any of claims 1 to 13 operating at gas pressure in the range 0.1 to 10 bar, preferably 1 bar.

15. The plasma processing method of claim 14, wherein the gas is one of steam, carbon dioxide, or air.

**Patentansprüche**

1. Plasmaofen (500), umfassend:

ein elektrisch leitfähiges Plasmagefäß (300), umfassend einen im Wesentlichen kreisförmigen Querschnitt, das dazu konfiguriert ist, elektromagnetische Leistung in einem transversalen elektrischen zylindrischen Wellenleitermodus, der überall der Kontur der Form des Plasmagefäßes folgt, entgegenzunehmen und auszubreiten, und
einen Moduswandler (400), der dazu konfiguriert ist, elektromagnetische Leistung, die in einem rechteckigen Wellenleitermodus entgegengenommen wird, in elektromagnetische Leistung in einem transversalen elektrischen zylindrischen Wellenleitermodus umzuwandeln und diese umgewandelte Leistung dem Plasmagefäß (300) zuzuführen, und
**dadurch gekennzeichnet, dass** das Plasmagefäß (300) elektrisch von dem Moduswandler (400) durch einen durchgehenden Spalt isoliert ist und der zylindrische Wellenleitermodus ein elektrisches Feld lokal parallel zu dem Spalt aufweist.

2. Plasmaofen (500) nach Anspruch 1, wobei der durchgehende Spalt (308) von einer Drosselstruktur (310) umgeben ist.

3. Plasmaofen (500) nach einem der Ansprüche 1 oder 2, wobei der durchgehende Spalt (308) einen Einlass für Gasströmung in das Plasmagefäß (300) bereitstellt.

4. Plasmaofen (500) nach einem vorhergehenden Anspruch, wobei das Plasmagefäß (300) einen konischen Abschnitt umfasst, der eine Plasmaerzeugungsregion des Plasmagefäßes (300) definiert.

5. Plasmaofen (500) nach Anspruch 4, wobei der konische Abschnitt des Plasmagefäßes (300) ein elektrisches Feld der elektromagnetischen Leistung in dem zylindrischen Wellenleitermodus komprimiert.

6. Plasmagefäß (300) nach Anspruch 4 oder 5, wobei ein zylindrischer Trennabschnitt den konischen Abschnitt des Plasmagefäßes (300) von dem durchgehenden Spalt (308) beabstandet.

7. Plasmaofen (500) nach einem vorhergehenden Anspruch, wobei das Plasmagefäß (300) einen zylindrischen Cut-off-Abschnitt (318) umfasst, der dazu bemessen ist, einen Cut-off-Modus für die elektromagnetische Leistung des zylindrischen Wellenleitermodus bereitzustellen, während ein Druckabfall während der Extraktion von Gasen minimiert wird.

8. Plasmaofen (500) nach einem vorhergehenden Anspruch, wobei das Plasmagefäß (300) ein Zündrohr (320), das den konischen Abschnitt durchdringt, und eine Sonde (322), die durch das Zündrohr (320) eingeführt ist, umfasst.

9. Plasmaofen (500) nach einem vorhergehenden Anspruch, wobei der Moduswandler (400) einen rechteckigen Wellenleiter mit einfacher Breite (408), einen rechteckigen Wellenleiter mit doppelter Breite (410), der mit dem rechteckigen Wellenleiter mit einfacher Breite (408) verbunden ist, und einen zylindrischen Wellenleiter (402), der mit dem rechteckigen Wellenleiter mit doppelter Breite (410) verbunden ist, umfasst.

10. Plasmaofen (500) nach Anspruch 9, wobei der Durchmesser des zylindrischen Wellenleiters (402) größer als das 1,22-Fache der Freiraumwellenlänge ist und größer als der rechteckige Wellenleiter mit doppelter Breite (410) ist.

11. Plasmaofen (500) nach Anspruch 9 oder 10, wobei der Moduswandler (400) ein Paar von zylindrischen Einsätzen (412) umfasst, die symmetrisch gegenüberliegend auf dem zylindrischen Wellenleiter sind und deren Mittelachsen parallel zu einer kurzen Wand der rechteckigen Wellenleiter mit einfacher und doppelter Breite ausgerichtet sind.

12. Plasmaofen (500) nach einem vorhergehenden Anspruch, der dazu konfiguriert ist, elektromagnetische Leistung mit einer Frequenz in dem Bereich 100 MHz bis 20 GHz entgegenzunehmen und auszubreiten.

13. Plasmaofen (500) nach einem vorhergehenden Anspruch, ferner umfassend einen Magnetron, der Leistung in dem rechteckigen TE01-Modus abgibt.

14. Verfahren zur Plasmaverarbeitung eines Synthesegases unter Verwendung eines Plasmaofens (500) gemäß einem der Ansprüche 1 bis 13, der bei einem Gasdruck in dem Bereich von 0,1 bis 10 bar, bevorzugt 1 bar, betrieben wird.

15. Plasmaverarbeitungsverfahren nach Anspruch 14, wobei das Gas eines von Dampf, Kohlendioxid oder Luft ist.

**Revendications**

1. Four à plasma (500), comprenant :

   un récipient à plasma électroconducteur (300) comprenant une section transversale sensiblement circulaire configurée pour recevoir et propager de l'énergie électromagnétique dans un mode de guide d'onde cylindrique électrique transversal qui suit partout le contour de la forme du récipient à plasma, et
   un convertisseur de mode (400) configuré pour convertir l'énergie électromagnétique reçue dans un mode de guide d'onde rectangulaire en énergie électromagnétique dans un mode de guide d'onde cylindrique électrique transversal, et fournir cette énergie convertie au récipient à plasma (300), et
   **caractérisé en ce que** le récipient à plasma (300) est électriquement isolé du convertisseur de mode (400) par un espace continu, et **en ce que** le mode de guide d'onde cylindrique présente un champ électrique localement parallèle à l'espace.

2. Four à plasma (500) selon la revendication 1, ledit espace continu (308) étant entouré d'une structure d'étranglement (310).

3. Four à plasma (500) selon l'une quelconque des revendications 1 et 2, ledit espace continu (308) assurant une entrée pour un écoulement de gaz dans le récipient à plasma (300).

4. Four à plasma (500) selon l'une quelconque des revendications précédentes, ledit récipient à plasma (300) comprenant une section conique qui définit une région de génération de plasma du récipient à plasma (300).

5. Four à plasma (500) selon la revendication 4, ladite section conique du récipient à plasma (300) comprimant un champ électrique de l'énergie électromagnétique dans le mode de guide d'onde cylindrique.

6. Récipient à plasma (300) selon la revendication 4 ou 5, une section de séparation cylindrique espaçant la section conique du récipient à plasma (300) de l'espace continu (308).

7. Four à plasma (500) selon l'une quelconque des revendications précédentes, ledit récipient à plasma (300) comprenant une section de coupure cylindrique (318) dimensionnée pour fournir un mode de coupure pour l'énergie électromagnétique en mode de guide d'onde cylindrique tout en minimisant une chute de pression pendant l'extraction des gaz.

8. Four à plasma (500) selon l'une quelconque des revendications précédentes, ledit récipient à plasma (300) comprenant un tube d'allumage (320) pénétrant dans la section conique et une sonde (322) insérée dans le tube d'allumage (320).

9. Four à plasma (500) selon l'une quelconque des revendications précédentes, ledit convertisseur de mode (400) comprenant un guide d'onde rectangulaire à largeur unique (408), un guide d'onde rectangulaire à largeur double (410) relié au guide d'onde rectangulaire à largeur unique (408), et un guide d'onde cylindrique (402) relié au guide d'onde rectangulaire à largeur double (410).

10. Four à plasma (500) selon la revendication 9, ledit diamètre du guide d'onde cylindrique (402) étant supérieur à 1,22 fois la longueur d'onde de l'espace libre et étant supérieur au guide d'onde rectangulaire à double largeur (410).

11. Four à plasma (500) selon la revendication 9 ou 10, ledit convertisseur de mode (400) comprenant une paire d'insertions cylindriques (412) symétriquement opposées sur le guide d'onde cylindrique et avec des axes centraux alignés parallèlement à une paroi courte des guides d'onde rectangulaires à largeur unique et double.

12. Four à plasma (500) selon l'une quelconque des revendications précédentes, configuré pour recevoir et propager de l'énergie électromagnétique ayant une fréquence de l'ordre de 100 MHz à 20 GHz.

13. Four à plasma (500) selon l'une quelconque des revendications précédentes, comprenant en outre un magnétron qui délivre de l'énergie dans le mode TE01 rectangulaire.

14. Procédé de traitement au plasma d'un gaz de synthèse au moyen d'un four à plasma (500) selon l'une quelconque des revendications 1 à 13 fonctionnant à une pression de gaz de l'ordre de 0,1 à 10 bar, de préférence de 1 bar.

15. Procédé de traitement au plasma selon la revendication 14, ledit gaz étant un gaz parmi de la vapeur, du dioxyde de carbone ou de l'air.

Fig. 1A

Fig. 1B

Start

202 — receive an electromagnetic guided wave in a rectangular waveguide with electric field polarisation transverse to the direction of energy flow and parallel to a narrow wall of the waveguide.

204 — convert the guided wave so it propagates along the axis of a cylindrical waveguide where the electric field is everywhere transverse to the direction of energy flow and where the electric field lines are circles concentric to the cross section of the cylindrical waveguide.

206 — transmit the electromagnetic field with cylindrical electric field to a plasma generation region of a plasma vessel.

End

Fig. 2

Fig. 3

Fig. 4

**EP 4 085 733 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H06287761 B
- EP 0264913 A2
- KR 101326670 B1
- CN 210075674

**Non-patent literature cited in the description**

- **R. G. CARTER**. Microwave and RF Vacuum Electronic Power Source. Cambridge University Press, 2018